# EUROPEAN PATENT APPLICATION

(11) **EP 2 857 638 A1**
(43) Date of publication of application: **08.04.2015**
(21) Application number: 13187122.0
(22) Date of filing: 02.10.2013
(51) Int. Cl.: F01D 5/28, C23C 28/00

(54) **A component for a turbomachine and a method for construction of the component**

(71) Applicant: Siemens Aktiengesellschaft, 80333 München (DE)
(72) Inventor: Stamm, Werner, 45481 Mülheim an der Ruhr (DE); Ahmad, Fathi, 41564 Kaarst (DE); Schumann, Eckart, 45468 Mülheim an der Ruhr (DE)

(57) **Abstract**

Component (1) for a turbomachine and method for construction thereof, the component comprising an inner core (6) and a first thermal bond coating (11) arranged on the inner core (6), and a second thermal bond coating (12) arranged on the first thermal bond coating (11). The first thermal bond coating (11) is sandwiched between the inner core (6) and the second thermal bond coating (12). A second operating temperature (T₂ₘₐₓ) of the second thermal bond coating (12) is higher than the first operating temperature (T₁ₘₐₓ) of the first thermal bond coating (11).

## Description

The present invention relates to the field of turbomachines, such as gas turbines and steam turbines, and particularly to a component for a turbomachine, such as aerofoils, and a method for construction of the component.

A turbomachine, for example a gas turbine or a steam turbine, is widely used in the field of power generation. During the course of power generation, the fuel in the turbomachine undergoes combustion, during which the chemical energy contained in the fuel is converted into mechanical energy, which is thereafter converted into electrical energy. The combustion of the fuel inside the turbomachine is a highly exothermic reaction, whereby tremendous amount of heat (greater than 1173K) is generated. Thus, the turbomachine and the various components thereof are required to operate at high temperatures to achieve high efficiency.

Certain components of the turbomachine are exposed to operating temperatures of the order of 1173K or more. As the operating temperatures increase, the aforementioned components of the turbomachine face higher thermal loading, either in the form of static temperature or in the form of temperature gradients. In order to overcome the harsh effects of high thermal loading, the temperature durability of the turbomachine components must correspondingly increase. For example, components such as blades and/or vanes of the turbomachine face higher thermal loading as compared to other parts of the turbomachine.

Currently, a thermal bond coating is used to provide insulation to these turbomachine components from the very high operating temperatures and the thermal loadings caused thereof. Typically, the aforementioned thermal bond coating comprises a metallic bond coating, a thermally grown oxide, and a ceramic topcoat. Components such as turbine blades and turbine vanes need the metallic coating as a bond coating or as an overlay coating. The metallic bond coating has a certain lifetime depending on its thickness and on the temperature and the time duration to which the same is exposed to during the operation of the turbomachine.

However, metallic bond coatings of different qualities and with different properties are available. Components of the turbomachine that are coated with a low quality bond coating should not be operated in high thermal loading conditions, because the low quality bond coating cannot withstand such high thermal loads, and the low quality bond coating would chip off or crack. Therefore, the low quality metallic bond coating would not be able to provide the necessary protection to components that are exposed to high operating temperature. However, the low quality bond coating would still be sufficient to protect components which are exposed to lower temperatures, for example operating temperatures less than 900°C. In order to overcome the aforementioned impediment, a high quality bond coating is used under the aforementioned high temperature conditions. However, a high quality bond coating is more expensive than the low quality bond coating. Therefore, the manufacturing cost of the components coated with the high quality bond coating and the turbomachine thereof increase tremendously.

Therefore, there is not only a need to optimise the manufacturing cost, but also to achieve a balance between performance and manufacturing cost for bond coatings, whereby the same can be applied to turbomachine components that are required to endure high thermal loads during operation of the turbomachine.

It is an object of the present invention to provide a solution for bond coating the turbomachine components that renders optimum performance, and also protects the turbomachine components adequately without the need to increase the manufacturing cost of the bond coated turbomachine components.

The aforementioned object is achieved by a component for a turbomachine according to claim 1, and a method for construction of the component according to claim 13.

The underlying object of the present invention is to reduce the manufacturing cost and optimise the performance of components for a turbomachine, especially if the components are exposed to very high operating temperatures, for example more than 1173K. A component comprising a bi-layered thermal bond coating approach comprising two different thermal bond coatings is disclosed herein for the achievement of the aforementioned object. The bi-layered thermal bond coating combines the advantages of the individual thermal bond coatings to render enhanced durability and the superior performance of the component.

The aforementioned component for the turbomachine comprises an inner core with an outer surface. A first thermal bond coating is arranged at least on a portion of the inner core. Thereafter a second thermal bond coating is arranged on the first thermal bond coating. The arrangement of the first and the second thermal bond coatings is such that the first thermal bond coating is sandwiched between the inner core and the second thermal bond coating. Herein, the maximum operating temperature T₂ₘₐₓ of the second thermal bond coating is greater than the maximum operating temperature T₁ₘₐₓ of the first thermal bond coating. The chemical compositions of the first and the second thermal bond coatings are different in order to render different maximum operating temperatures.

Herein the maximum operating temperature refers to a temperature for which the coating is still intact on the inner core, i.e. the coating is not destroyed or cracked or broken until the maximum operating temperature is attained. Nevertheless, the first thermal bond coating can be arranged on the entire extent of the inner core, and thereafter the second thermal bond coating can be arranged on the first thermal bond coating. Therewith, the entire component is thermally bond coated in a bi-layered manner. Furthermore, the component can be an aerofoil, a platform segment whereon the aerofoil is mounted, et cetera.

In accordance with an embodiment of the present invention, a thickness (t₁) of the first thermal bond coating is greater than a thickness (t₂) of the second thermal bond coating. Therewith, it is beneficial for reducing the manufacturing cost of the component if the first thermal bond coating comprises an inexpensive low quality bond coat material and the second thermal bond coating comprises an expensive high quality bond coat material.

In accordance with further embodiments of the present invention, the thickness (t₂) of the second thermal bond coating lies in the range of 10 µm to 100 µm, and the thickness (t₁) of the first thermal bond coating lies in the range of 100 µm to 300 µm. The aforementioned thicknesses (t₁ and t₂) of the first and the second thermal bond coatings are beneficial to achieve optimal thermal performance and optimal cost reduction of the component.

In accordance with another embodiment of the present invention, the first thermal bond coating is capable of adsorbing Sulphur. Therewith, the inner core can be protected from Sulphur attacks, because the Sulphur is adsorbed by the first thermal bond coating. Thus, the operational life of the component is enhanced.

In accordance with yet another embodiment of the present invention, a Sulphur adsorption coefficient of the first thermal bond coating is greater than a Sulphur adsorption coefficient of the second thermal bond coating. This feature is beneficial in offering an enhanced protection of the inner core even in the event of depletion of the second thermal bond coating due to Sulphur attacks on the second thermal bond coating.

In accordance with yet another embodiment of the present invention, a percentage of Chromium present in the first thermal bond coating is greater than a percentage of Chromium present in the second thermal bond coating. The capability of Chromium to adsorb Sulphur is exploited herein. A higher presence of Chromium in the first thermal bond coating as compared to the second thermal bond coating is beneficial in rendering enhanced protection to the inner core in the event of depletion of the second thermal bond coating.

In accordance with yet another embodiment of the present invention, the second thermal bond coating comprises Rhenium. Rhenium enhances the durability and the wear resistance of the component. Additionally, the component can be exposed to higher operating temperatures due to the presence of Rhenium. Furthermore, the oxidation of the component is reduced due to the presence of Rhenium. Therewith, the operational life of the component and the thermal performance of the component are enhanced.

In accordance with further embodiments of the present invention, the first maximum temperature T₁ₘₐₓ is less than or equal to 1173K, and the second maximum temperature T₂ₘₐₓ is greater than 1173K.

In accordance with yet another embodiment of the present invention, an outer ceramic coating is comprised in the component. The outer ceramic coating is arranged on the second thermal bond coating. The arrangement of the outer ceramic coating is such that the second thermal bond coating is sandwiched between the portion of the inner core and the outer ceramic coating. The inner core, the first thermal bond coating, and the second thermal bond coating are protected by the presence of the outer ceramic core.

In accordance with a method for construction of the component according to any of the aforementioned embodiments, the first thermal bond coating is provided on the inner core, and the second thermal bond coating is provided on the first thermal bond coating.

In accordance with further embodiments of the present invention, the first thermal bond coating is provided on the inner core by overlaying the first thermal bond coating on the inner core. The second thermal bond coating is provided on the first thermal bond coating by overlaying the second thermal bond coating on the first thermal bond coating.

In accordance with another embodiment of the present invention, the overlaying of the bond coating can be provided by any of the processes, viz. Electron Beam Physical Vapor Deposition, Air Plasma Spray, High Velocity Oxygen Fuel, Electrostatic Spray Assisted Vapour Deposition, and Direct Vapour Deposition.

The aforementioned and other embodiments of the present invention related to a component for a turbomachine and a method for construction of the component will now be addressed with reference to the accompanying drawings of the present invention. The illustrated embodiments are intended to illustrate, but not to limit the invention. The accompanying drawings herewith contain the following figures, in which like numbers refer to like parts, throughout the description and drawings.

The figures illustrate in a schematic manner further examples of the embodiments of the invention, in which:
- FIG 1: depicts a perspective view of an exemplary component for the turbomachine,
- FIG 2: depicts a cross-sectional view of the component referred to in FIG 1 along a section II-II,
- FIG 3: depicts a portion III of the component referred to in FIG 2 in accordance with one or more embodiments of the present invention, and
- FIG 4: depicts a flowchart of a method for construction of the component referred to in FIG 1.

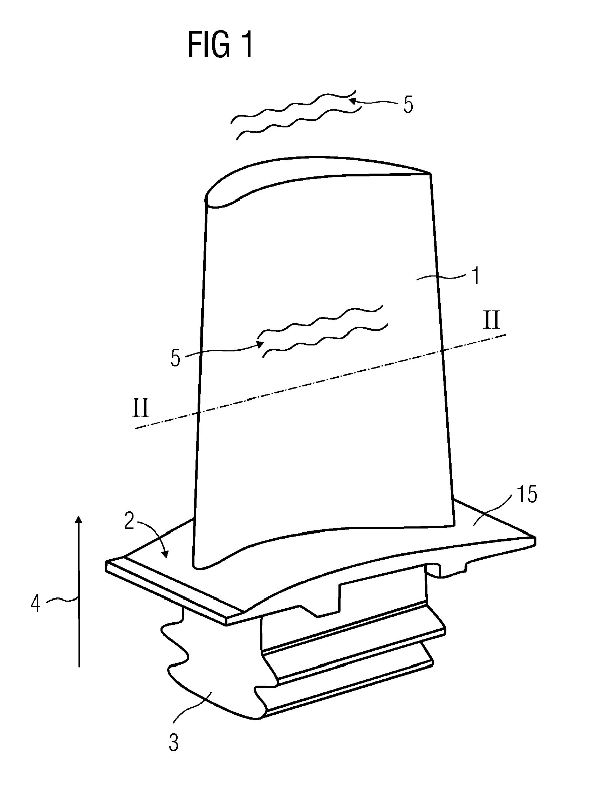

A perspective view of an exemplary component 1 for a turbomachine (not shown), in accordance with one or more embodiments of the present invention, is depicted in figure 1.

For the purpose of elucidation of the present invention, the component 1 of figure 1 is considered to be an exemplary aerofoil for the turbomachine. Herein, the aerofoil 1 can either be a rotatable blade comprised in a rotor section (not shown) of the turbomachine or the aerofoil 1 can be a stationary vane comprised in a stator section (not shown) of the turbomachine.

The aerofoil 1 according to figure 1 is arranged on a platform segment 2 and the platform segment 2 is furthermore attached to a root segment 3. The aerofoil 1 extends in a radially outward direction 4 from the platform section 2, and the radially outward direction 4 is indicated by means of a reference arrow '4'. Herein, the radial direction 4 is perpendicular to an axis of rotation of the rotor of the turbomachine. The platform segment 2 and the root segment 3 facilitate contiguous arrangement of a plurality of such aerofoils 1, therewith facilitating the construction of either the stator section and/or the rotor section for the turbomachine.

It may be noted herein that the aforementioned turbomachine can be construed to be a gas turbine, a steam turbine, a turbofan, et cetera. The turbomachine is used in the field of power generation, wherein the chemical energy and/or the mechanical energy of a working fluid is converted into mechanical and/or electrical energy. The aerofoil 1 is subjected to extremely high temperatures (for example, greater 1273K) during the operation of the aforementioned turbomachine. Furthermore, the aerofoil 1 can be subjected to extremely high temperature gradients, i.e. varying temperatures. Thus, extremely high thermal fatigues are experienced by the aerofoil 1 during its operation. In addition to the aforementioned thermal fatigues, the aerofoil 1 experiences mechanical fatigue either by virtue of movement of the aerofoil 1 and/or the movement of hot gases 5 over the aerofoil 1. Furthermore, the aerofoil 1 is subjected to contact with various chemicals and contaminants present in the fuel and/or the working fluid, which can cause mechanical abrasions, corrosions, et cetera, thereby resulting in surface damages, wear and tear of the aerofoil 1, et cetera. Therewith, a reduction in the operational life of the aerofoil 1 is experienced. The manner in which the operational life of the aerofoil 1 can be enhanced in accordance with the teachings of the present invention is elucidated in the subsequent paragraphs.

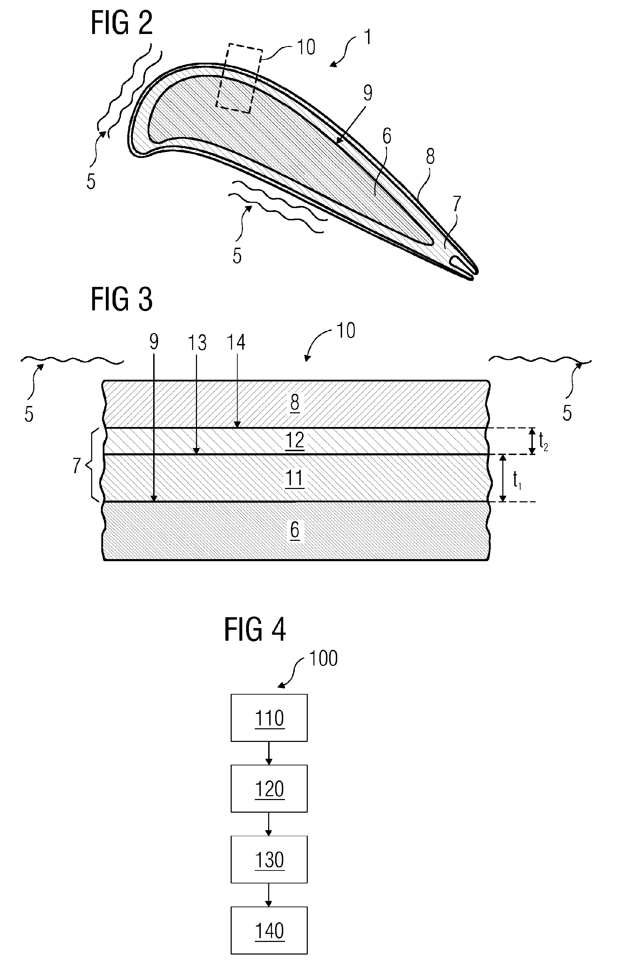

A cross-sectional view of the aerofoil 1 as viewed along a section II-II is depicted in figure 2.

The aerofoil 1 comprises an inner core 6, a thermal bond coating layer 7, and an outer ceramic coating 8. The inner core 6 can either be a solid core or a hollow core, and the inner core 6 can be constructed from a metal, an alloy, a composite material, et cetera. The inner core 6 comprises an outer surface 9 whereon the thermal bond coating layer 7 is arranged. Thereafter, the outer ceramic coating 8 is arranged on the thermal bond coating layer 7. It may be noted herein that the thermal bond coating layer 7 is sandwiched between the inner core 6 and the outer ceramic coating 8.

Herein, the manner of arrangement of the thermal bond coating layer 7 on the inner core 6 can be achieved by overlaying the thermal bond coating layer 7 on the inner core 6. The overlaying of the thermal bond coating layer 7 on the inner core 6 can be achieved by using any of the well-known processes such as Electron Beam Physical Vapor Deposition, Air Plasma Spray, High Velocity Oxygen Fuel, Electrostatic Spray Assisted Vapour Deposition, Direct Vapour Deposition, et cetera. The aforementioned techniques for overlaying the thermal bond coating layer 7 on the inner core 6 are well-known in the art, and the same is not elucidated herein for the purpose of brevity.

It may be noted herein that in the aerofoil 1 elucidated in figure 2, the entire inner core 6 is overlaid with the thermal bond coating layer 7. However, without loss of generality, it is also possible to overlay the thermal bond coating layer 7 only on a certain region of the inner core 6. Thereafter, the outer ceramic coating 8 is overlaid on the thermal bond coating layer 7, which is overlaid on the certain region of the inner core 6. The aforementioned region may be selected based on an analysis of the thermal stresses, the mechanical stresses and the spallation that can be possibly experienced during the operation of the aerofoil 1. For example, the aforementioned region can be a hotspot, which is prone to experience very high thermal stresses, mechanical stresses and spallation.

A magnified portion 10 of the aerofoil 1 comprising the inner core 6, the thermal bond coating layer 7, and the outer ceramic coating 8 is depicted in figure 3.

Reference is made herein to the preceding figures for the purpose of elucidation of FIG 3. In accordance with the present invention, the thermal bond coating layer 7 comprises a first thermal bond coating 11 and a second thermal bond coating 12. The first thermal bond coating 11 and the second thermal bond coating 12 are two different bond coatings. For example, the thermal bond coatings 11,12 can be metallic bond coatings. However, the first thermal bond coating 11 and the second thermal bond coating 12 together form the thermal bond coating layer 7.
The first thermal bond coating 11 is preferably arranged on the outer surface 9 of the inner core 6, which may be achieved for example by overlaying the first thermal bond coating 11 on the outer surface 9 of the inner core 6 by means of any of the aforementioned processes. Similarly, the second thermal bond coating 12 is preferably arranged on the first thermal bond coating 11, which may again be achieved for example by overlaying the second thermal bond coating 12 on an outer surface 13 of the first thermal bond coating 11 again by means of any of the aforementioned processes.

Thereafter, the outer ceramic coating 8 is overlaid on an outer surface 14 of the second thermal bond coating 12. It may be noted herein that the second thermal bond coating 12 is sandwiched between the inner core 6 and the outer ceramic coating 8.

Herein, the second thermal bond coating 12 comprises a superior quality material, compared to the material comprised in the first thermal bond coating 11. Correspondingly, the material comprised in the second thermal bond coating 12 is more expensive than the material comprised in the first thermal bond coating 11. For example, the second thermal bond coating 12 can comprise: Cobalt - 24 to 26%, Chromium - 16 to 18%, Aluminium - 9.5 to 11%, Yttrium - 0.2 to 0.4%, Rhenium-1.2 to 1.8%, and the remaining comprises Nickel. The first bond coating can comprise: Nickel - 29 to 31%, Chromium - 27 to 29%, Aluminium - 7 to 8%, Yttrium - 0.5 to 0.7%, Silicon-0.3 to 0.7% Si, and the remaining comprises Cobalt.

Herein it may be noted that the first thermal bond coating 11 is capable of adsorbing Sulphur, because the first thermal bond coating 11 comprises Chromium. During the operation of the turbomachine, the aerofoil 1 is exposed to sulphur dioxide, which is produced as a result of the combustion of fuel in the turbomachine. The exposure of the aerofoil 1 to Sulphur can lead to material damages, which can hamper the operation of the aerofoil. In such a scenario, the inner core 6 of the aerofoil can therewith be protected from Sulphur attacks arising thereof, because the first thermal bond coating 11 is arranged on the outer surface 9 of inner core 6, and the first thermal bond coating 11 is capable of adsorbing Sulphur.

Herein, it may be noted that the percentage content of Chromium in the first thermal bond coating 11 is preferably greater than the percentage content of Chromium in the second thermal bond coating 12. Therefore, a Sulphur adsorption coefficient of the first thermal bond coating 11 is greater than a Sulphur adsorption coefficient of the second thermal bond coating 12, because of enhanced availability of Chromium in the first thermal bond coating 11 compared to the second thermal bond coating 12. Therewith, the protection of the inner core 6 of the aerofoil 1 can be enhanced even if the second thermal bond coating 12 experiences depletion due to the aforementioned sulphur attacks.

Herein, "the Sulphur adsorption coefficient" is to be construed as the ratio of mass of Sulphur adsorbed per unit mass of the thermal bond coating material.

Due to oxidation of the outer surface 14 of the second thermal bond coating 12 during the operation of the aerofoil 1, a thermally grown oxide can be formed between the second thermal bond coating 12 and the outer ceramic coating 8. The thermally grown oxide can hamper the bonding between the second thermal bond coating 12 and the outer ceramic coating 8. According to an exemplary aspect of the present invention, the rate of growth of the thermally grown oxide can be reduced due to a higher percentage content of Aluminium in the second thermal bond coating 12 compared to the first thermal bond coating 11. The higher percentage content of Aluminium in the second thermal bond coating 12 facilitates the formation of the Alfa-Alumina, which is thermodynamically stable, and reduces the rate of growth of the thermally grown oxide.

In accordance with one or more embodiments of the present invention, the first thermal bond coating 11 and the second thermal bond coating 12 are optimised to operate up to a first maximum temperature T₁ₘₐₓ and a second maximum temperature T₂ₘₐₓ respectively. Since the second thermal bond coating 12 is arranged underneath the outer ceramic coating 8, and since the first thermal bond coating 11 is arranged underneath the second thermal bond coating 12, the second thermal bond coating 12 experiences higher thermal stresses compared to the first thermal bond coating 11 during the operation of the aerofoil 1, because of the proximity of the second thermal bond coating 12 to the hot gases 5. Furthermore, the latency of heat transfer from the outer ceramic coating 8 to the second thermal bond coating 11 is lesser compared to the latency of heat transfer from the second thermal bond coating 12 to the first thermal bond coating 11. Considering the aforementioned factors, the second maximum temperature T₂ₘₐₓ is preferably higher than the first maximum temperature T₁ₘₐₓ. Thus, the second thermal bond coating 12 is capable of withstanding higher temperatures than the first thermal bond coating 11.

It may be noted herein that the second thermal bond coating 12 is capable of operating at temperatures far greater than 1173k, and the first thermal bond coating 11 comprising SC 2231 is capable of operating at temperatures less than 1173k.

In order to optimise the cost of the thermal bond coating layer 7, in accordance with one or more other embodiments of the present invention, a thickness t₁ of a first thermal bond coating 11 is greater than a thickness t₂ of the second thermal bond coating 12. The thickness t₁ of the first thermal bond coating 11 lies in the range of 100 µm to 300 µm, whereas the thickness t₂ of the second thermal bond coating 12 lies in the range of 10 µm to 100 µm. Preferably, a 200 µm thick first thermal bond coating 11 and a 10 to 100 µm thick second thermal bond coating 12 is an optimal configuration of the thermal bond coating layer 7 for the aerofoil 1. In addition to the aforementioned advantage, the inner core 6 of the aerofoil 1 is protectable to a greater extent if the thickness t₁ of the first thermal bond coating 11 is greater than the thickness t₂ of second thermal bond coating 12, because the first thermal bond coating 11 will be capable of adsorbing more Sulphur compared to the second thermal bond coating 12, and therewith the depletion of the first thermal bond coating 12 is reduced. Therewith the operational life of the aerofoil 1 is extended.

Furthermore, it may be noted herein that the second thermal bond coating 12 is arranged as a coarse layer on the first thermal bond coating 11. The coarseness of the second thermal bond coating 12 facilitates the achievement of enhanced bonding with the outer ceramic coating 8, thereby enhancing the rigidity of the aerofoil 1.

In the event of a development of a crack in the outer ceramic coating 8, which may be experienced during the operation of the aerofoil, the second thermal bond coating 12 is exposed to the working fluid, and the fuel used in the turbomachine. The fuel, the working fluid, and the contaminants thereof can cause oxidation and spallation of the second thermal bond coating 12, thereby leading to the depletion of the second thermal bond coating 12. This phenomenon can subsequently expose the first thermal bond coating 11 and thereafter the inner core 6, thereby leading to a progressive degradation of the aerofoil 1. In order to prevent the depletion and the resulting degradation of the second thermal bond coating 12, according to another embodiment of the present invention, the second thermal bond coating 12 comprises Rhenium. Rhenium facilitates the operation of the second thermal bond coating 12 to very high operational temperatures, for example up to 2500°C. I.e., it is possible to enhance the second maximum temperature T₂ₘₐₓ. Additionally, Rhenium is also resistant to water vapour, which is advantageous in the prevention of oxidation and corrosion of the second thermal bond coating 12. Furthermore, the excellent wear resistance of Rhenium renders strength and durability to the second thermal bond coating 12.

A flowchart 100 of a method for construction of the aerofoil 1 in accordance with one or more embodiments of the present invention is depicted in FIG 4.

In step 110, the inner core of the aerofoil 1 is provided. In step 120, the first thermal bond coating 11 is provided on the portion 10 of the inner core 6. The first thermal bond coating 11 can be provided by overlaying the first thermal bond coating 11 on the outer surface 9 of the inner core 6 by means of any of the aforementioned processes. In step 130, the second thermal bond coating 12 is provided on the first thermal bond coating 11. The second thermal bond coating 12 can be provided by overlaying the second thermal bond coating 12 on the outer surface 13 of the first thermal bond coating 11 by means of any of the aforementioned processes. Thereafter, in step 140, the outer ceramic coating 8 is provided on the second thermal bond coating 12. The outer ceramic coating 8 can be provided by overlaying the outer ceramic coating 8 on the outer surface 14 of the second thermal bond coating 12 in accordance with any of the aforementioned well-known processes.

Herein, referring to the preceding figures and elucidations thereof in the aforementioned paragraphs, it may be noted that the teachings of the present invention can also be used for the construction of a cost-effective and a highly durable platform segment 2. Herein, the platform segment 2 would comprise an inner core (not shown) with an outer surface 15, whereon a first thermal bond coating can be overlaid. Preferably, the outer surface 15 is the radial outer surface of the platform segment 2 as depicted in FIG 1. Subsequently, a second thermal bond coating can be overlaid on the first thermal bond coating. An outer ceramic coating can be overlaid on the second thermal bond coating, thereby facilitating the obtainment of the platform segment.

Though the invention has been described herein with reference to specific embodiments, this description is not meant to be construed in a limiting sense. Various examples of the disclosed embodiments, as well as alternate embodiments of the invention, will become apparent to persons skilled in the art upon reference to the description of the invention. It is therefore contemplated that such modifications can be made without departing from the embodiments of the present invention as defined.

## Claims

1. A component (1) for a turbomachine, wherein the component comprises an inner core (6) with an outer surface (9), the component (1) further comprising:
- a first thermal bond coating (11) arranged on the outer surface (9) on at least a portion (10) of the inner core (6), wherein the first thermal bond coating (11) is optimized to operate up to a first maximum temperature (T₁ₘₐₓ), and
- a second thermal bond coating (12), wherein the second thermal bond coating (12) is arranged on the first thermal bond coating (11) such that the first thermal bond coating (11) is located between the second thermal bond coating (12) and the outer surface (10) of the inner core (6), wherein the second thermal bond coating (12) is optimized to operate up to a second maximum temperature (T₂ₘₐₓ),
wherein the second maximum temperature (T₂ₘₐₓ) is greater than the first maximum temperature (T₁ₘₐₓ).

2. The component (1) according to claim 1, wherein a thickness (t₁) of the first thermal bond coating (11) is greater than a thickness (t₂) of the second thermal bond coating (12).

3. The component (1) according to claim 2, wherein the thickness (t₂) of the second thermal bond coating (12) is in the range of 10 µm to 100 µm.

4. The component (1) according to claim 2 or claim 3, wherein the thickness (t₁) of the first thermal bond coating (11) is in the range of 100 µm to 300 µm.

5. The component (1) according to any of the claims 1 to 4, wherein the first thermal bond coating (11) is capable of adsorbing Sulphur.

6. The component (1) according to any of the claims 1 to 5, wherein a Sulphur adsorption coefficient of the first thermal bond coating (11) is greater than a Sulphur adsorption coefficient of the second thermal bond coating (12).

7. The component (1) according to any of the claims 1 to 6, wherein the second thermal bond coating (12) comprises Rhenium.

8. The component (1) according to any of the claims 1 to 7, wherein the first maximum temperature (T₁ₘₐₓ) is less than or equal to 900°C.

9. The component (1) according to any of the claims 1 to 8, wherein the second maximum temperature (T₂ₘₐₓ) is greater than 900°C.

10. The component (1) according to any of the claims 1 to 9, wherein a percentage of Chromium comprised in the first thermal bond coating (11) is greater than a percentage of Chromium comprised in the second thermal bond coating (12).

11. The component (1) according to any of the claims 1 to 10, further comprising an outer ceramic coating (8), wherein the outer ceramic coating (8) is arranged on the second thermal bond coating (12), such that the first thermal bond coating (11) and the second thermal bond coating (12) are sandwiched between the outer surface (9) of the inner core (6) and the outer ceramic coating (8).

12. The component according to any of the claims 1 to 11, wherein the second thermal bond coating 12 can comprise: Cobalt - 24 to 26%, Chromium - 16 to 18%, Aluminium - 9.5 to 11%, Yttrium - 0.2 to 0.4%, Rhenium - 1.2 to 1.8%, and the remaining comprises Nickel, and/or wherein the first bond coating can comprise: Nickel - 29 to 31%, Chromium - 27 to 29%, Aluminium - 7 to 8%, Yttrium - 0.5 to 0.7%, Silicon - 0.3 to 0.7% Si, and the remaining comprises Cobalt.

13. A method for construction of the component (1) for the turbomachine according to any one of claims 1 to 12, the method comprising:
- a step (120) of providing the first thermal bond coating (11) on the outer surface (9) on the portion (10) of the inner core (6), and
- a step (130) of providing the second thermal bond coating (12) on the first metallic thermal bond coating (11).

14. The method according to claim 13, wherein the step (120) of providing the first thermal bond coating (11) comprises overlaying the first thermal bond coating (11) on the outer surface (9) on the portion (10) of the inner core (6).

15. The method according to claim 13 or claim 14, wherein the step (130) of providing the second thermal bond coating (12) comprises overlaying the second thermal bond coating (12) on the first thermal bond coating (11).

16. The method according to any of the claims 13 to 15, wherein at least one of the first thermal bond coating (11) and the second thermal bond coating (12) is provided by means of a process selected from a group comprising Electron Beam Physical Vapor Deposition, Air Plasma Spray, High Velocity Oxygen Fuel, Electrostatic Spray Assisted Vapour Deposition, and Direct Vapour Deposition.
